(19) **Europäisches Patentamt**

**European Patent Office**

**Office européen des brevets**

(11) **EP 1 077 530 B1**

(12) **FASCICULE DE BREVET EUROPEEN**

(45) Date de publication et mention
de la délivrance du brevet:
**06.05.2004 Bulletin 2004/19**

(51) Int Cl.⁷: **H03M 3/02**

(21) Numéro de dépôt: **00402185.3**

(22) Date de dépôt: **28.07.2000**

(54) **Procédé et dispositif de conversion d'un signal analogique en un signal numérique avec contrôle automatique de gain**

Verfahren und Anordnung zur Wandlung eines Analogsignals in einem Digitalsignal mit automatischer Verstärkungsregelung

Method and arrangement for the conversion of an analogue signal into a digital signal with automatic gain control

(84) Etats contractants désignés:
**DE FR GB IT**

(30) Priorité: **16.08.1999 FR 9910523**

(43) Date de publication de la demande:
**21.02.2001 Bulletin 2001/08**

(73) Titulaire: **STMicroelectronics S.A.**
**92120 Montrouge (FR)**

(72) Inventeur: **Mellot, Pascal**
**38250 Lans en Vercors (FR)**

(74) Mandataire: **Casalonga, Axel**
**BUREAU D.A. CASALONGA - JOSSE**
**Paul-Heyse-Strasse 33**
**80336 München (DE)**

(56) Documents cités:
**EP-A- 0 607 711          JP-A- 10 247 852**

• **"A/D CONVERTER USES SIGMA-DELTA MODULATION TO RESOLVE 16 BITS AT 100 KHZ" EDN ELECTRICAL DESIGN NEWS,US,CAHNERS PUBLISHING CO. NEWTON, MASSACHUSETTS, vol. 34, no. 11, 25 mai 1989 (1989-05-25), pages 109-110, XP000048533 ISSN: 0012-7515**

## Description

L'invention concerne la conversion d'un signal analogique en un signal numérique avec contrôle automatique de gain.

L'invention s'applique avantageusement mais non limitativement dans le domaine du traitement de la parole et de la transmission de la voix, par exemple lors de séances de vidéoconférence.

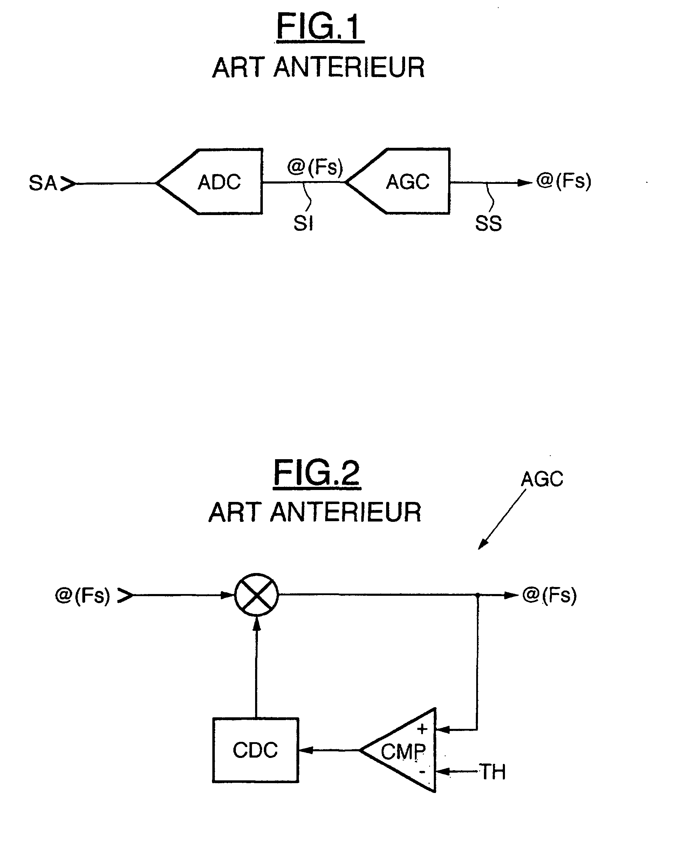

La figure 1 illustre de façon schématique un dispositif de l'art antérieur destiné à convertir un signal analogique en un signal numérique avec contrôle automatique de gain. Plus précisément, ce dispositif comporte un convertisseur analogique numérique ADC recevant en entrée le signal analogique SA et délivrant en sortie un signal numérique SI échantillonné à la fréquence d'échantillonnage de sortie Fs. Les échantillons @ du signal numérique SI sont successivement délivrés à un moyen de contrôle automatique de gain AGC qui délivre en sortie un signal numérique SS dont les échantillons @ ont une amplitude égale au produit de l'amplitude des échantillons d'entrée par un gain.

Lorsque l'amplitude du signal analogique SA, et par conséquent l'amplitude du signal numérique SI (niveau des échantillons) augmente, le moyen AGC va alors ajuster la valeur du gain de façon à restituer en sortie des échantillons dont le niveau est égal au niveau des échantillons avant le saut d'amplitude.

La figure 2 illustre de façon schématique un tel moyen AGC de l'art antérieur. Celui-ci comporte en entrée un multiplieur recevant d'une part au rythme de la fréquence d'échantillonnage Fs les échantillons du signal numérique SI délivrés par le convertisseur ADC et, d'autre part, la sortie d'un compteur-décompteur CDC dont l'entrée est rebouclée sur la sortie du multiplieur par l'intermédiaire d'un comparateur CMP. L'autre entrée du comparateur CMP reçoit un seuil fixe mais programmable TH. En fonctionnement, lorsque le niveau de l'échantillon de sortie est supérieur au seuil TH, la valeur du compteur-décompteur CDC, c'est-à-dire la valeur du gain, décroît par étage, au rythme de la fréquence de travail du compteur-décompteur CDC (fréquence de travail qui est bien supérieure à la fréquence d'échantillonnage Fs). Par contre, si le niveau de l'échantillon de sortie est inférieur au seuil TH, la valeur du compteur-décompteur va augmenter par étage.

En réponse à une brusque augmentation du niveau d'amplitude du signal analogique, il est généralement spécifié que l'amplitude du signal numérique SS délivré par le moyen AGC doive revenir à la valeur initiale au bout d'une durée prédéterminée Tatt, qui varie selon les applications.

L'obtention de la valeur spécifiée pour la durée Tatt est réalisée en modulant la durée de fonctionnement du compteur-décompteur au sein de chaque période d'échantillonnage Ts.

Or, selon les applications, cette durée Tatt peut être courte et inférieure à la période Ts d'échantillonnage correspondant à la fréquence d'échantillonnage Fs.

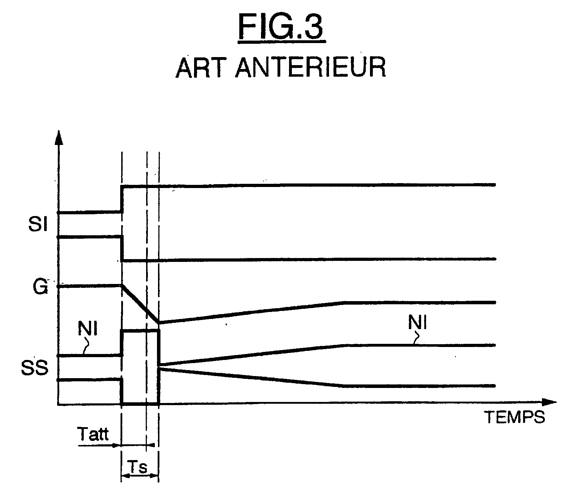

Dans ce cas, puisque le moyen de contrôle automatique de gain AGC va corriger le gain plusieurs fois pendant la période d'échantillonnage Ts, et que pendant cette période d'échantillonnage, le niveau de l'échantillon d'entrée (et par conséquent le niveau de l'échantillon de sortie présent sur l'entrée + du comparateur) est constant, il ne peut pas y avoir de convergence du moyen AGC. En d'autres termes, le moyen AGC ne peut plus réagir proprement comme illustré sur la figure 3. On voit en effet sur cette figure 3, qu'au cours de la période d'échantillonnage Ts au début de laquelle le signal numérique SI délivré par le convertisseur a subi une impulsion d'amplitude, le niveau du signal de sortie SS du moyen AGC subit également une impulsion d'amplitude puis reste constant. Pendant cette période, le gain G décroît continuellement. Et, lorsqu'au début de la période d'échantillonnage suivante, l'échantillon suivant du signal SI est délivré en entrée du moyen AGC, le niveau du signal SS chute brutalement en-dessous du niveau initial NI avant de remonter progressivement à ce niveau initial NI au cours des périodes d'échantillonnage suivantes. Il se produit alors en quelque sorte un effet de pompage sur le gain, ce qui se traduit dans des applications de traitement de la parole, par des oscillations audibles.

L'invention vise à apporter une solution à ce problème.

L'invention propose donc un procédé de conversion d'un signal analogique en un signal numérique avec contrôle automatique de gain, dans lequel on délivre le signal analogique en entrée d'un convertisseur analogique/numérique de type delta-sigma ayant une fréquence d'échantillonnage de sortie et on effectue le contrôle automatique de gain dans le convertisseur en aval du modulateur delta-sigma du convertisseur, sur un signal numérique intermédiaire échantillonné à une fréquence d'échantillonnage intermédiaire supérieure à la fréquence d'échantillonnage de sortie.

En d'autres termes, l'invention prévoit en combinaison l'utilisation d'un convertisseur analogique/numérique de type delta-sigma pour effectuer la conversion analogique numérique, et la réalisation du contrôle automatique de gain dans ce convertisseur, en utilisant la particularité offerte par un convertisseur delta-sigma de disposer de signaux numériques suréchantillonnés par rapport à la fréquence d'échantillonnage de sortie. Ainsi, le fait d'effectuer le contrôle automatique de gain sur des échantillons intermédiaires délivrés à une fréquence d'échantillonnage intermédiaire plus élevée que la fréquence d'échantillonnage de sortie permet d'obtenir des durées Tatt faibles et inférieures à la période d'échantillonnage du signal numérique obtenu (période d'échantillonnage correspondant à la fréquence d'échantillonnage de sortie du convertisseur) tout en évitant l'effet de pompage de l'art antérieur.

En théorie, on pourrait effectuer le contrôle automatique de gain en tout point situé en aval du modulateur delta-sigma, et notamment directement en sortie du modulateur delta-sigma. Cependant, afin d'obtenir une meilleure précision, il est préférable d'effectuer le contrôle automatique de gain sur des échantillons intermédiaires ayant un nombre relativement grand de bits (meilleure résolution). C'est la raison pour laquelle, il est avantageux d'effectuer ce contrôle automatique de gain sur les échantillons du signal intermédiaire délivré par un filtre décimateur en peigne connecté en sortie du modulateur delta-sigma.

Dans certaines applications, il est requis d'effectuer une phase de calibration préalable du convertisseur de façon à tenir compte du décalage (offset) introduit par le modulateur delta-sigma.

Lorsqu'une telle phase de calibration préalable est requise, l'invention prévoit, dans un mode de mise en oeuvre particulier, de délivrer en entrée du convertisseur, un signal analogique de calibration constant et d'élaborer en un emplacement du convertisseur, ci-après dénommé emplacement de calibration, situé entre le modulateur et l'endroit où l'on effectue le contrôle automatique de gain, un mot numérique de calibration à partir des échantillons numériques délivrés en cet emplacement de calibration. Par ailleurs, une fois que cette phase de calibration est effectuée, on soustrait à chaque échantillon délivré audit emplacement de calibration et issu du signal analogique d'entrée à convertir, le mot numérique de calibration, de façon à former des échantillons numériques intermédiaires sur lesquels on effectue le contrôle automatique de gain.

En d'autres termes, on calcule l'offset de calibration en un emplacement situé en amont du contrôle automatique de gain, et non en aval de ce contrôle de façon que le calcul de cet offset de calibration soit effectué indépendamment des valeurs de gain que peut prendre le moyen de contrôle automatique de gain.

Là encore, l'emplacement de calibration pourrait se situer directement en sortie du modulateur delta-sigma. Cependant, toujours dans le but d'obtenir une plus grande précision sur l'offset de calibration (mot numérique de calibration), il est préférable que cet emplacement de calibration se situe à la sortie du filtre décimateur en peigne.

Il est par ailleurs avantageux, mais non indispensable, que pendant la phase de calibration, l'élaboration du mot numérique de calibration comporte un filtrage passe bas des échantillons numériques délivrés audit emplacement de calibration. En effet, ceci permet d'effectuer une réjection de certaines fréquences qui pourraient être présentes en raison de bruits, et qui pourraient de ce fait perturber la phase de calibration.

L'invention a également pour objet un dispositif de conversion analogique/numérique avec contrôle automatique de gain. Selon une caractéristique générale de l'invention, ce dispositif comprend un convertisseur analogique/numérique du type delta-sigma comportant un modulateur delta-sigma et un filtre décimateur de sortie, et des moyens de contrôle automatique de gain incorporés dans le convertisseur entre le modulateur et le filtre décimateur de sortie.

Selon un mode particulier de réalisation de l'invention, le convertisseur comporte également un filtre décimateur en peigne disposé entre le modulateur et le filtre décimateur de sortie, et les moyens de contrôle automatique de gain sont alors avantageusement disposés entre le filtre en peigne et le filtre décimateur de sortie.

Lorsqu'une calibration est envisagée, le dispositif comprend avantageusement des moyens de calibration comprenant :

- un multiplexeur possédant une entrée connectée à la sortie du filtre décimateur en peigne, et une première et une deuxième sorties,
- des moyens de soustraction possédant une première entrée connectée à la première sortie du multiplexeur, une deuxième entrée et une sortie reliée à l'entrée des moyens de contrôle automatique de gain,
- un moyen de mémoire (par exemple un registre) connecté entre la deuxième sortie du multiplexeur et la deuxième entrée des moyens de soustraction, et
- des moyens de commande aptes à relier l'entrée du multiplexeur à sa deuxième sortie pendant une phase de calibration pour stocker dans le moyen de mémoire un mot numérique de calibration en réponse à un signal analogique de calibration constant présent à l'entrée du convertisseur, et à relier l'entrée du multiplexeur à sa première sortie dans une phase de fonctionnement normal du convertisseur.

Les moyens de calibration comportent avantageusement un filtre passe bas rebouclé sur le moyen de mémoire pendant la phase de calibration.

Ce filtre passe bas comporte, dans un mode de réalisation, au moins un moyen de décalage de bits à gauche, connecté entre la sortie du moyen de mémoire et l'entrée du moyen de mémoire par l'intermédiaire d'un additionneur, ainsi qu'un moyen supplémentaire de décalage à gauche de bits, connecté entre la deuxième sortie du multiplexeur et l'additionneur.

D'autres avantages et caractéristiques de l'invention apparaîtront à l'examen de là description détaillée de mode de mise en oeuvre et de réalisation, nullement limitatifs et des dessins annexés sur lesquels :

- les figures 1, 2 et 3 déjà décrites illustrent schématiquement un dispositif de conversion analogique/numérique avec contrôle automatique de gain selon l'art antérieur et son mode de fonctionnement dans un cas particulier,
- la figure 4 illustre schématiquement l'architecture interne d'un dispositif de conversion analogique/numérique selon l'invention,
- la figure 5 illustre plus en détails mais toujours de façon schématique, l'architecture interne du modulateur delta-sigma du convertisseur de la figure 4,

- la figure 6 illustre la fonction de transfert d'un filtre décimateur en peigne présent dans le convertisseur de la figure 4,

- la figure 7 illustre plus en détails et toujours schématiquement l'architecture interne d'un moyen de contrôle automatique de gain selon l'invention,

- la figure 8 illustre un mode de fonctionnement d'un convertisseur selon l'invention,

- la figure 9 illustre également schématiquement un autre mode de réalisation d'un convertisseur selon l'invention équipé de moyens de calibration, et

- la figure 10 illustre schématiquement plus en détails une partie des moyens de calibration équipant le convertisseur de la figure 9.

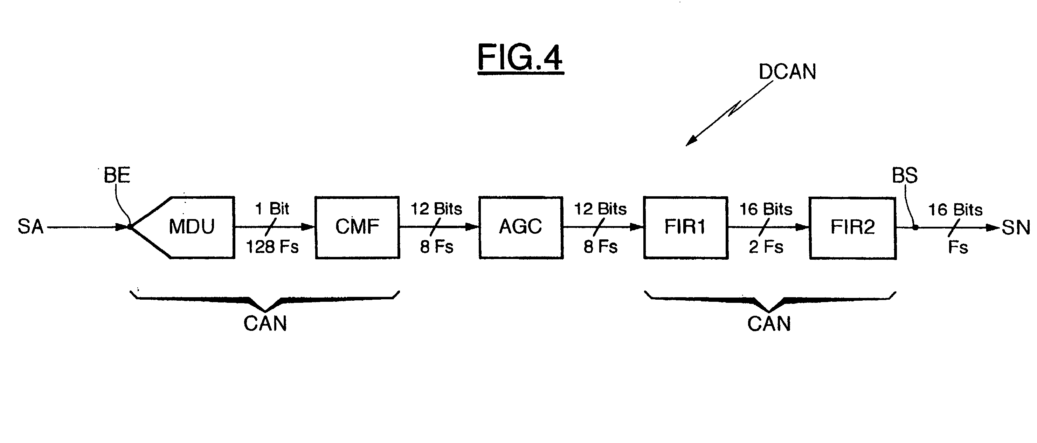

Sur la figure 4, la référence DCAN désigne un dispositif de conversion analogique numérique avec contrôle automatique de gain selon l'invention.

Le dispositif DCAN comporte essentiellement d'une part un convertisseur analogique numérique CAN de type delta-sigma et d'autre part un moyen de contrôle automatique de gain AGC. La structure d'un convertisseur analogique/numérique de type delta-sigma est classique et connue par l'homme du métier. On va en rappeler ci-après les principales caractéristiques, l'homme du métier pouvant également se référer à toutes fins utiles, à l'ouvrage de Steven R. Northworthy, Richard Schreier, Gabor C. Temes intitulé "Delta-Sigma Data Convertors Theory, Designs and Simulation" édité par IEEE Press (Piscataway, USA).

La structure d'un moyen de contrôle automatique de gain est également classique et connue en soi.

Le rôle du convertisseur analogique/numérique de type delta-sigma est d'échantillonner un signal analogique d'entrée SA en un signal numérique de sortie SN à une fréquence d'échantillonnage prédéterminée Fs, cette fréquence étant également dénommée dans la suite du texte fréquence d'échantillonnage de sortie. Ce convertisseur delta-sigma comporte notamment en tête un modulateur de type delta-sigma, référencé MDU, et en sortie, un voire plusieurs (par exemple 2) filtres décimateurs de sortie par exemple des filtres à réponse impulsionnelle finie.

La caractéristique essentielle de l'invention consiste, non seulement à utiliser un convertisseur analogique de type delta-sigma pour effectuer la conversion analogique/numérique, mais également en combinaison, à incorporer les moyens de contrôle automatique de gain AGC à l'intérieur même du convertisseur analogique/numérique, c'est-à-dire entre le modulateur de type delta-sigma et le filtre décimateur de sortie, et ce de façon à effectuer le contrôle automatique de gain sur un signal numérique suréchantillonné, c'est-à-dire ayant une fréquence d'échantillonnage intermédiaire supérieure à la fréquence d'échantillonnage de sortie du signal numérique de sortie.

Plus précisément, comme illustré sur la figure 4, la borne d'entrée BE du dispositif DCAN est également la borne d'entrée du modulateur delta-sigma MDU. Dans l'exemple décrit, le modulateur MDU délivre en sortie un signal échantillonné sur un bit, la fréquence d'échantillonnage étant égale à 128 fois la fréquence d'échantillonnage de sortie. Les échantillons successifs de 1 bit sont délivrés à un filtre décimateur en peigne de structure classique CMF qui délivre en sortie des échantillons numériques intermédiaires formés de 12 bits, à une fréquence d'échantillonnage intermédiaire égale à 8 fois la fréquence d'échantillonnage de sortie Fs. C'est sur les échantillons de ce signal intermédiaire suréchantillonné que va s'effectuer le contrôle automatique de gain.

Les moyens de contrôle automatique de gain AGC délivrent donc un signal de sortie également échantillonné à la fréquence 8Fs et formé d'échantillons de 12 bits. Ces échantillons sont ensuite traités dans un premier filtre décimateur FIR1 délivrant en sortie des échantillons de 16 bits à la fréquence d'échantillonnage 2Fs. Après passage dans un deuxième filtre décimateur à réponse impulsionnelle finie FIR2, les échantillons de sortie (de 16 bits chacun) sont successivement délivrés à la borne de sortie BS du dispositif DCAN à la fréquence d'échantillonnage Fs et forment le signal numérique de sortie SN.

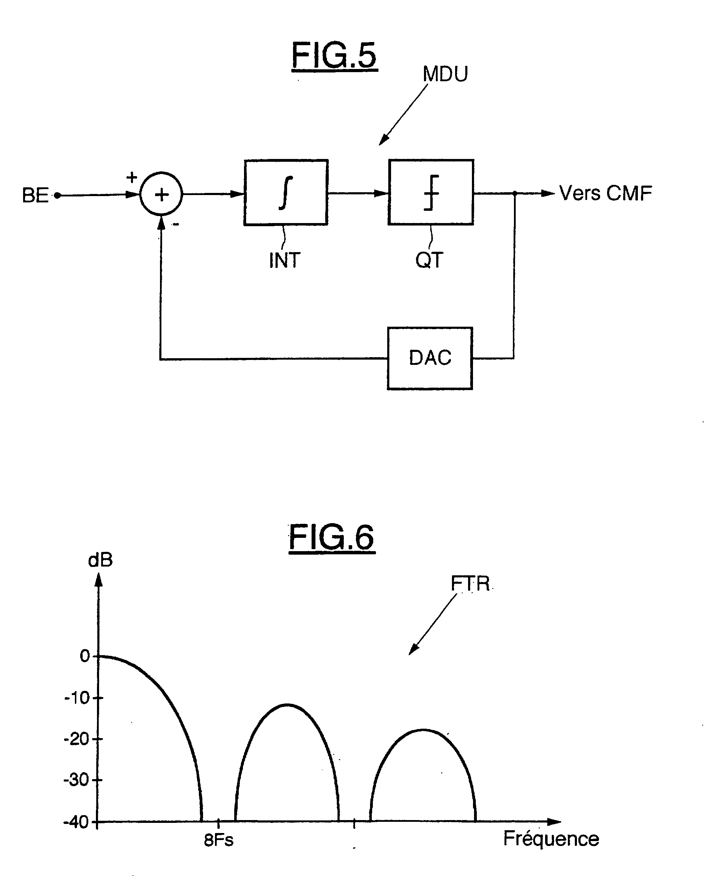

Le modulateur MDU (figure 5) comporte en tête un soustracteur relié à la borne d'entrée BE. Ce soustracteur est suivi d'un intégrateur INT et d'un moyen de quantification QT dont la sortie constitue la sortie du modulateur. La sortie du quantificateur QT est rebouclée sur l'autre entrée du soustracteur par un convertisseur numérique/analogique DAC. La modulation "delta" est basée sur la quantification de la modification du signal échantillon à échantillon, plutôt que sur la quantification de la valeur absolue du signal à chaque échantillon.

La présence de l'intégrateur INT (sigma) dans le modulateur confère au modulateur la dénomination de modulateur "delta-sigma".

La sortie du modulateur delta-sigma est à une fréquence d'échantillonnage très élevée. C'est une caractéristique fondamentale des modulateurs delta-sigma parce qu'ils utilisent la portion haute fréquence du spectre pour placer la majeure partie du bruit de quantification. En effet, un modulateur delta-sigma est conçu pour supprimer le bruit de quantification dans la bande de base.

La diminution de la fréquence d'échantillonnage de sortie du modulateur delta-sigma est ensuite réalisée dans un filtre décimateur dont la fonction consiste notamment à éliminer le bruit de quantification situé en-dehors de la bande de base pour ne laisser qu'une petite portion du bruit de quantification dans la bande de base (ce qui revient à augmenter la résolution effective de la sortie), puis à effectuer une décimation, c'est-à-dire une réduction de la fréquence d'échantillonnage.

Une solution pour effectuer ces fonctions consiste à utiliser un filtre décimateur à réponse impulsionnelle finie. Cependant, la façon la plus économique et la plus simple de réduire la fréquence d'échantillonnage à la sortie du modulateur delta-sigma est d'utiliser en filtre décimateur en peigne, dont la structure est bien connue de l'homme du métier, ce filtre en peigne étant simplement un filtre à réponse impulsionnelle finie dont tous les coefficients sont égaux à 1 et qui se comporte comme un simple accumulateur effectuant une moyenne glissante. La fonction de transfert FTR d'un tel filtre en peigne, par exemple d'ordre 1 est illustrée schématiquement sur la figure 6. L'utilisation d'un filtre décimateur en peigne présente notamment l'avantage de ne réquérir aucun multiplieur ni de nécessiter aucun stockage pour les coefficients du filtre.

A la sortie du filtre en peigne, le signal numérique intermédiaire est formé d'échantillons de 12 bits délivrés successivement à la fréquence d'échantillonnage intermédiaire égale à 8 fois la fréquence d'échantillonnage de sortie Fs.

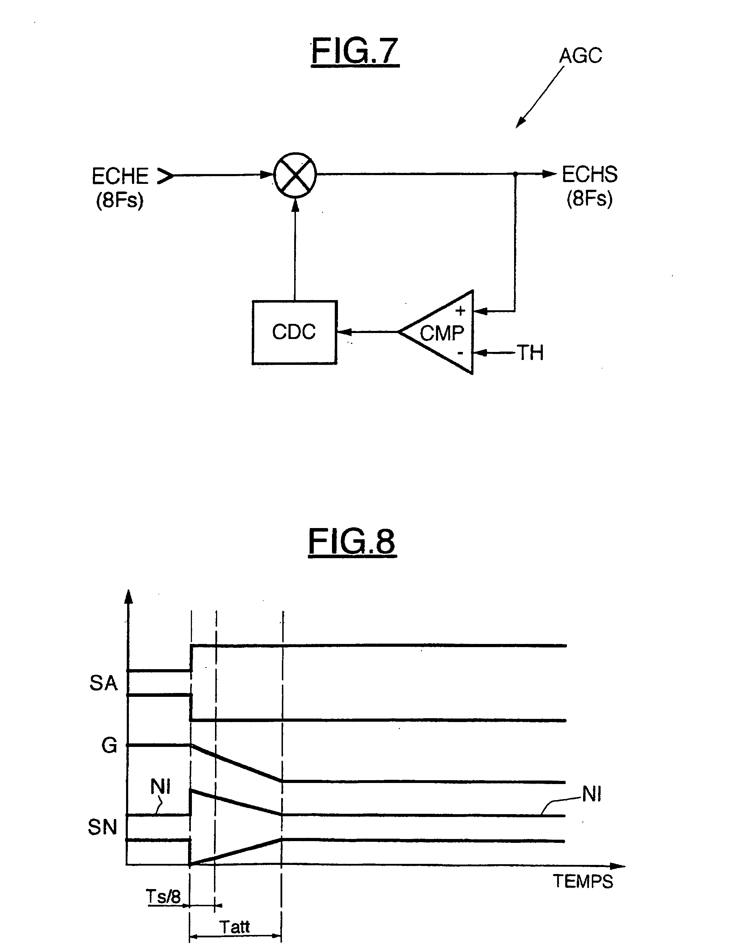

Les échantillons ECHE de ce signal intermédiaire sont ensuite délivrés dans le moyen de contrôle automatique de gain AGC (figure 7) qui délivre en sortie des échantillons ECHS, également à la fréquence 8Fs, chaque échantillon ECHS étant égal au produit de l'échantillon d'entrée ECHE correspondant par le gain fourni par le compteur-décompteur CDC. La structure et le fonctionnement du moyen AGC sont identiques à ceux qui ont été décrits en référence à la figure 2.

La seule différence réside ici dans le fait que le moyen AGC opère sur un signal intermédiaire suréchantillonné par rapport au signal numérique de sortie.

Il serait possible, dans certaines applications où la précision n'est pas critique, d'effectuer le contrôle automatique de gain directement en sortie du modulateur delta-sigma sur des échantillons de 1 bit.

Cependant pour des applications où la précision est importante, il est préférable d'effectuer ce contrôle automatique de gain sur des échantillons ayant une plus grande résolution. C'est la raison pour laquelle on effectue ce contrôle automatique de gain de préférence à la sortie du filtre en peigne CMF.

Le moyen de contrôle automatique de gain AGC est suivi de l'étage de sortie habituel d'un convertisseur delta-sigma, formé d'un voire de plusieurs filtres décimateurs de sortie qui sont classiquement des filtres passe bas à réponse impulsionnelle finie. Dans l'exemple décrit, l'étage de sortie du convertisseur de la figure 4 comporte un premier filtre décimateur de sortie FIR1 qui réduit la fréquence d'échantillonnage à 2Fs tout en augmentant la résolution à 16 bits. Le deuxième filtre décimateur de sortie FIR2 réduit encore la fréquence d'échantillonnage pour obtenir la fréquence d'échantillonnage de sortie Fs tout en maintenant la résolution de sortie de 16 bits.

La figure 8 illustre le fonctionnement d'un dispositif selon l'invention dans le cas d'une impulsion d'amplitude sur le signal analogique d'entrée SA.

Le fait de travailler sur un signal suréchantillonné permet, en réglant la durée de fonctionnement du compteur-décompteur au sein de chaque période de suréchantillonnage Ts/8, d'obtenir de faibles variations de gain et d'obtenir une variation lente et linéaire du gain durant toute la période Tatt de façon à récupérer pour le signal numérique SN son niveau initial NI sans effet de pompage ni oscillation audible.

En d'autres termes, l'invention permet de réaliser de façon simple et sans coût supplémentaire, un dispositif de conversion analogique/numérique qui peut supporter une durée d'attaque Tatt égale à un multiple de la durée d'attaque admissible pour un dispositif de l'art antérieur, en l'espèce 8 fois supérieure dans l'exemple particulier qui vient d'être décrit.

Bien entendu, dans l'exemple qui vient d'être décrit la durée Tatt devra néanmoins rester supérieure à Ts/8 pour éviter les effets indésirables d'oscillation et de pompage.

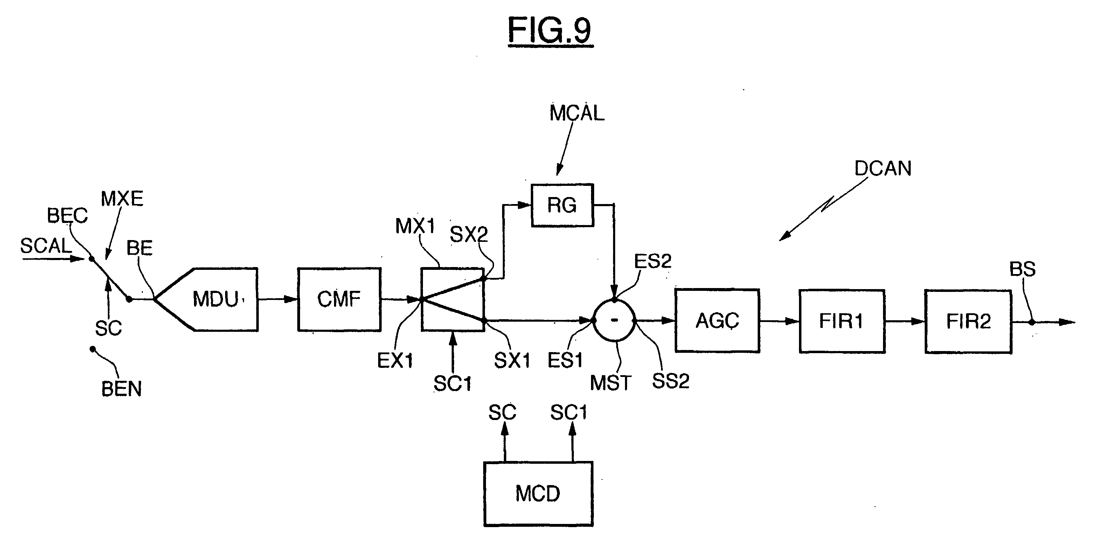

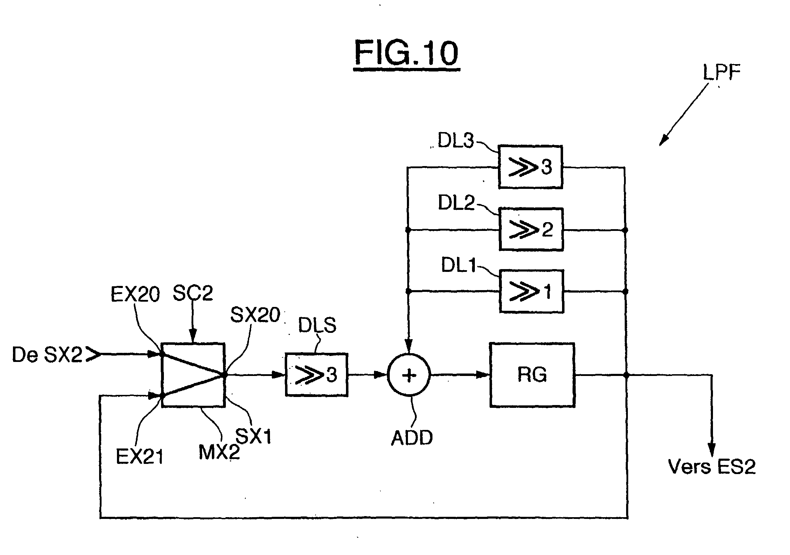

Dans certaines applications, il est nécessaire de calibrer le dispositif de conversion analogique/numérique selon l'invention. Dans ce cas, ce dispositif comporte avantageusement des moyens de calibration MCAL tels que ceux illustrés schématiquement sur la figure 9 et sur la figure 10. Sur ces figures, les éléments analogues à ceux représentés sur la figure 4 ont les mêmes références que celles portées sur la figure 4. On ne décrira ici que les différences entre les figures 9 et 10 'une part et la figure 4 d'autre part.

La calibration du dispositif consiste en fait à calibrer le modulateur delta-sigma MDU en déterminant la tension continue de décalage (DC offset) de la partie analogique du modulateur MDU.

A cet égard, pendant la phase de calibration, on délivre en entrée du dispositif DCAN un signal de calibration SCAL qui est en l'espèce une tension analogique constante (par exemple la valeur 0 ou la valeur Vcc/2 si Vcc désigne la tension d'alimentation du dispositif). On détermine alors un mot numérique, dit de calibration, correspondant à la conversion analogique numérique de ce signal de calibration SCAL. Ce mot numérique de calibration sera ensuite soustrait, en fonctionnement normal, au signal numérique résultant de la conversion d'un signal analogique à convertir.

La présence du moyen de contrôle automatique de gain AGC au sein même du convertisseur delta-sigma nécessite de choisir convenablement l'emplacement, dit emplacement de calibration, où l'on va déterminer le mot numérique de calibration. Et, selon l'invention, il est nécessaire que cet emplacement de calibration se situe entre la sortie du modulateur delta-sigma MDU et l'entrée du moyen de contrôle automatique de gain afin que le mot numérique de calibration soit indépendant de la valeur du gain délivré par le compteur-décompteur du moyen AGC au cours de la phase de calibration.

Bien entendu, il serait possible en théorie d'élaborer le mot numérique de calibration directement en sortie du modulateur delta-sigma. Cependant, toujours pour des raisons de précision, il est préférable d'élaborer ce mot numérique de calibration en utilisant des échantillons de résolution plus élevée. C'est la raison pour laquelle on placera les moyens de calibration MCAL de préférence entre le filtre en peigne CMF et le moyen de contrôle automatique de gain AGC.

Comme illustré sur la figure 9, pour effectuer les calibrations, il est prévu que le dispositif DCAN comporte en tête un multiplexeur MXE dont une première entrée est reliée à une borne d'entrée de calibration BEC destinée à recevoir le signal de calibration SCAL, et dont une deuxième entrée forme la borne d'entrée BEN destinée en fonctionnement normal, c'est-à-dire après calibration, à recevoir les signaux analogiques à convertir. Ce multiplexeur MXE est commandé par un signal de commande SC, par exemple un signal logique à deux états, délivré par des moyens de commande MCD de structure classique et non représentés ici en détails à des fins de simplification.

Les moyens de calibration MCAL comportent par ailleurs un multiplexeur MX1 possédant une entrée EX1 connectée à la sortie du filtre décimateur en peigne CMF, une première sortie SX1 et une deuxième sortie SX2. Ce multiplexeur est commandé par un signal de commande SC1

Lés moyens de calibration comportent également des moyens de soustraction MST possédant une première entrée ES 1 connectée à la première sortie SX1 du multiplexeur, une deuxième entrée ES2 et une sortie SS2 reliée à l'entrée des moyens de contrôle automatique de gain AGC.

Les moyens de calibration comportent encore un moyen de mémoire RG, par exemple un registre (formé par exemple dans le cas présent de 12 bascules destinées chacune à stocker un bit de l'échantillon délivré par le filtre CMF). Ce moyen de mémoire est connecté entre la deuxième sortie SX2 du multiplexeur et la deuxième entrée ES2 des moyens de soustraction MST.

Enfin, les moyens de commande sont aptes à relier l'entrée EX1 du multiplexeur MX1 à sa deuxième sortie SX2 pendant la phase de calibration de façon à stocker dans le moyen de mémoire le mot numérique de calibration correspondant au signal analogique de calibration constant SCAL présent à l'entrée BEC du convertisseur. Par ailleurs, les moyens de commande relient l'entrée EX1 du multiplexeur à sa première sortie SX1 dans la phase de fonctionnement normal du convertisseur, c'est-à-dire après calibration. Ainsi, en phase de fonctionnement normal, le contenu du moyen de mémoire RG, qui est égal au mot de calibration, est soustrait aux échantillons délivrés par le filtre en peigne CMF et correspondant au signal analogique à convertir et présent sur la borne d'entrée BEN.

Il est particulièrement avantageux, dans certaines applications d'adjoindre un filtre passe bas aux moyens de calibration afin d'éliminer certaines fréquences dûes au bruit et qui pourraient perturber la calibration.

Dans ce cas, on prévoit avantageusement un filtre passe bas rebouclé sur le moyen de mémoire pendant la phase de calibration.

La figure 10 illustre un mode de réalisation d'un tel filtre passe bas LPF qui se caractérise notamment par sa simplicité.

Ainsi, sur la figure 10, on réalise très simplement un filtre passe bas du premier ordre ayant une fréquence de coupure égale à 0,021 fois la fréquence d'échantillonnage intermédiaire (égale à 8Fs).

L'équation numérique d'un tel filtre est définie par la formule :

$$RG = 7/8RG + 1/8SX2$$

dans laquelle RG désigne ici à des fins de la simplification le contenu du registre RG et SX2 désigne la valeur de sortie du filtre en peigne CMF.

Ce filtre passe bas LPF comporte alors trois moyens de décalage de bits à gauche DL1, DL2 et DL3 qui sont tous rebouclés entre la sortie du registre RG et l'entrée du registre RG par l'intermédiaire d'un additionneur ADD. Plus précisément, le moyen DL1 effectue un décalage de 1 bit à gauche tandis que le moyen DL2 effectue un décalage de 2 bits à gauche et que le moyen DL3 effectue un décalage de 3 bits à gauche.

L'ensemble de ces trois moyens DL1, DL2 et DL3 permet de réaliser le coefficient 7/8ème (qui est égal à 1/2 + 1/4 + 1/8).

Par ailleurs, le filtre LPF comporte également un moyen supplémentaire DLS de décalage à gauche de bits, en l'espèce un moyen de décalage à gauche de 3 bits qui est relié entre la sortie d'un multiplexeur MX2 et l'autre entrée de l'additionneur ADD.

Ce moyen de décalage à gauche DLS permet de réaliser le coefficient multiplicateur 1/8.

Le multiplexeur MX2 possède une première entrée EX20 qui est reliée à la sortie SX2 du multiplexeur MX1, ainsi qu'une deuxième entrée EX21 qui est reliée à la sortie du registre RG.

Pendant la phase de calibration, le signal de commande SC2 (signal logique à deux états par exemple) relie l'entrée EX20 du multiplexeur MX2 à sa sortie SX20 de façon à prendre en compte la sortie du filtre CMF. On laisse le système converger pendant un certain temps jusqu'à ce que le contenu du registre RG ne varie quasiment plus, ce contenu étant alors égal au mot de calibration.

En fonctionnement normal, c'est-à-dire une fois que la calibration a été effectuée, on commande le multiplexeur MX2 par le signal SC2 de façon à relier son entrée EX21 à sa sortie SX20. Le contenu du registre RG demeure alors constant.

**Revendications**

1. Procédé de conversion d'un signal analogique en un signal numérique avec contrôle automatique de gain, **caractérisé par le fait qu'**on délivre le signal analogique (SA) en entrée d'un convertisseur analogique/numérique de type delta-sigma (CAN) ayant une fréquence d'échantillonnage de sortie (Fs) et on effectue le contrôle automatique de gain (AGC) dans le convertisseur, en aval du modulateur delta-sigma (MDU) du convertisseur, sur un signal numérique intermédiaire échantillonné à une fréquence d'échantillonnage intermédiaire (8Fs) supérieure à la fréquence d'échantillonnage de sortie (Fs).

2. Procédé selon la revendication 1, **caractérisé par le fait qu'**on effectue le contrôle automatique de gain sur les échantillons du signal intermédiaire délivrés par un filtre décimateur en peigne (CMF) connecté en sortie du modulateur delta-sigma (MDU).

3. Procédé selon la revendication 1 ou 2, **caractérisé par le fait qu'**il comporte une phase de calibration préalable du convertisseur dans laquelle on délivre en entrée du convertisseur un signal analogique de calibration constant (SCAL), et on élabore en un emplacement de calibration du convertisseur situé entre le modulateur et l'endroit où l'on effectue le contrôle automatique de gain, un mot numérique de calibration (RG) à partir des échantillons numériques délivrés en cet emplacement de calibration, et **par le fait que**, une fois cette phase de calibration effectuée, on soustrait à chaque échantillon délivré audit emplacement de calibration et issu du signal analogique d'entrée à convertir, le mot numérique de calibration, de façon à former des échantillons numériques intermédiaires sur lesquels on effectue le contrôle automatique de gain.

4. Procédé selon les revendications 2 et 3, **caractérisé par le fait que** ledit emplacement de calibration se situe à la sortie du filtre décimateur en peigne (CMF).

5. Procédé selon la revendication 3 -ou 4, **caractérisé par le fait que** pendant la phase de calibration l'élaboration du mot numérique de calibration comporte un filtrage passe-bas (LPF) des échantillons-numériques délivrés audit emplacement de calibration.

6. Dispositif de conversion analogique/numérique avec contrôle automatique de gain, **caractérisé par le fait qu'**il comprend un convertisseur analogique/numérique du type delta-sigma (CAN) comportant un modulateur delta-sigma (MDU) et un filtre décimateur de sortie (FIR1, FIR2), et des moyens de contrôle automatique de gain (AGC) incorporés dans le convertisseur (CAN) entre le modulateur (MDU) et le filtre décimateur de sortie (FIR1, FIR2).

7. Dispositif selon la revendication 6, **caractérisé par le fait que** le convertisseur (CAN) comporte également un filtre décimateur en peigne (CMF) disposé entre le modulateur (MDU) et le filtre de sortie (FIR1), et **par le fait que** les moyens de contrôle automatique de gain (AGC) sont disposés entre le filtre en peigne (CMF) et le filtre de sortie (FIR1).

8. Dispositif selon la revendication 7, **caractérisé par le fait qu'**il comprend des moyens de calibration (MCAL) comprenant

   un multiplexeur (MX1) possédant une entrée (EX1) connectée à la sortie du filtre décimateur en peigne (CMF) et une première et une deuxième sorties (SX1, SX2),
   des moyens de soustraction (MST) possédant une première entrée (ES1) connectée à la première sortie (EX1) du multiplexeur, une deuxième entrée (ES2) et une sortie (SS2) reliée à l'entrée des moyens de contrôle automatique de gain (AGC),
   un moyen de mémoire (RG) connecté entre la deuxième sortie (SX2) du multiplexeur et la deuxième entrée (ES2) des moyens de soustraction, et
   des moyens de commande (MCD) aptes à relier l'entrée (EX1) du multiplexeur (MX1) à sa deuxième sortie (SX2) pendant une phase de calibration pour stocker dans le moyen de mémoire (RG) un mot numérique de calibration en réponse à un signal analogique de calibration constant (SCAL) présent à l'entrée du convertisseur, et à relier l'entrée (EX1) du multiplexeur (MX1) à sa première sortie (SX1) dans une phase de fonctionnement normal du convertisseur.

9. Dispositif selon la revendication 8, **caractérisé par le fait que** les moyens de calibration comportent un filtre passe-bas (LPF) rebouclé sur le moyen de mémoire pendant la phase de calibration.

10. Dispositif selon la revendication 9, **caractérisé par le fait que** le filtre passe-bas comporte au moins un moyen de décalage de bits à gauche (DL1, DL2, DL3) connecté entre la sortie du moyen de mémoire (RG) et l'entrée du moyen de mémoire (RG) par l'intermédiaire d'un additionneur (ADD), ainsi qu'un moyen supplémentaire de décalage à gauche de bits (DLS) connecté entre la deuxième sortie (SX2) du multiplexeur (MX1) et l'additionneur (ADD).

**Patentansprüche**

1. Verfahren zur Wandlung eines Analogsignals in ein Digitalsignal mit automatischer Verstärkungsregelung, **dadurch gekennzeichnet, daß** das Analogsignal (SA) am Eingang eines Analog/Digital-Wandlers des Typs Delta-Sigma (CAN), der eine Ausgangsabtastfrequenz (Fs) hat, bereitgestellt wird und die automatische Verstärküngsregelung (AGC) im Wandler nach dem Delta-Sigma-Modulator (MDU) des Wandlers an einem abgetasteten digitalen Zwischensignal ausgeführt wird, das eine Zwischenabtastfrequenz (8Fs) hat, die höher ist als die Ausgangsabtastfrequenz (Fs).

2. Verfahren nach Anspruch 1, **dadurch gekennzeichnet, daß** die automatische Verstärkungsregelung an den Abtastwerten des Zwischensignals ausgeführt wird, die von einem Kammreduzierfilter (CMF) ausgegeben werden, das mit dem Ausgang des Delta-Sigma-Modulators (MDU) verbunden ist.

3. Verfahren nach Anspruch 1 oder 2, **dadurch gekennzeichnet, daß** es eine Phase der Vorkalibrierung des Wandlers aufweist, in welcher am Eingang des Wandlers ein Analogsignal konstanter Kalibrierung (SCAL) bereitgestellt wird und an einem Kalibrierungsort des Wandlers, der zwischen dem Wandler und der Stelle angeordnet ist, wo die automatische Verstärkungsregelung ausgeführt wird, aus den an diesem Kalibrierungsort bereitgestellten digitalen Abtastwerten ein digitales Kalibrierungswort ausgearbeitet wird, und dadurch, daß, sobald einmal dieser Kalibrierungsschritt ausgeführt worden ist, bei jedem Abtastwert, der dem Kalibrierungsort zugeführt wird und der von dem umzuwandelnden analogen Eingangssignal stammt, das digitale Kalibrierungswort subtrahiert wird, um so digitale Zwischenabtastwerte zu bilden, an welchen die automatische Verstärkungsregelung ausgeführt wird.

4. Verfahren nach den Ansprüchen 2 und 3, **dadurch gekennzeichnet, daß** der Kalibrierungsort am Ausgang des Kammreduzierfilters (CMF) angeordnet ist.

5. Verfahren nach Anspruch 3 oder 4, **dadurch gekennzeichnet, daß** während der Kalibrierungsphase die Ausarbeitung des digitalen Kalibrierungsworts eine Tiefpaßfilterung (LPF) der dem Kalibrierungsort zugeführten digitalen Abtastwerte aufweist.

6. Analog/Digital-Wandleranordnung mit automatischer Verstärkungsregelung, **dadurch gekennzeichnet, daß** sie einen Analog/Digital-Wandler des Typs Delta-Sigma (CAN), der einen Delta-Sigma-Modulator (MDU) und ein Ausgangsreduzierfilter (FIR1,FIR2) aufweist, und Einrichtungen zur automatischen Verstärkungsregelung (AGC) aufweist, die in dem Wandler (CAN) zwischen dem Modulator (MDU) und dem Ausgangsreduzierfilter (FIR1,FIR2) angeordnet sind.

7. Anordnung nach Anspruch 6, **dadurch gekennzeichnet, daß** der Wandler (CAN) außerdem ein Kammreduzierfilter (CMF) aufweist, das zwischen dem Modulator (MDU) und dem Ausgangsfilter (FIR1) angeordnet ist, und dadurch, daß die Einrichtungen zur automatischen Verstärkungsregelung (AGC) zwischen dem Kammfilter (CMF) und dem Ausgangsfilter (FIR1) angeordnet sind.

8. Anordnung nach Anspruch 7, **dadurch gekennzeichnet, daß** sie Kalibrierungseinrichtungen (MCAL) aufweist, mit:

   einem Multiplexer (MX1), der einen Eingang (EX1), der mit dem Ausgang des Kammreduzierfilters (CMF) verbunden ist, und einen ersten und einen zweiten Ausgang (SX1,SX2) besitzt,
   Subtraktionseinrichtungen (MST), die einen ersten Eingang (ES1), der mit dem ersten Ausgang (EX1) des Multiplexers verbunden ist, einen zweiten Eingang (ES2) und einen Ausgang (SS2) besitzen, der an dem Eingang der Einrichtungen zur automatischen Verstärkungssteuerung angeschlossen ist,
   einer Speichereinrichtung (RG), die zwischen dem zweiten Ausgang (SX2) des Multiplexers und dem zweiten Eingang (ES2) der Subtraktionseinrichtungen angeordnet ist, und
   Steuerungseinrichtungen (MCD), welche während einer Kalibrierungsphase den Eingang (EX1) des Multiplexers (MX1) mit seinem zweiten Ausgang (SX2) verbinden können, um als Antwort auf ein am Eingang des Wandlers anliegendes analoges Signal der Kalibrierungskonstanten (SCAL) ein digitales Kalibrierungswort in der Speichereinrichtung (RG) zu speichern, und welche in einer normalen Betriebsphase des Wandlers den Eingang (EX1) des Multiplexers (MX1) mit seinem ersten Ausgang (SX1) verbinden können.

9. Anordnung nach Anspruch 8, **dadurch gekennzeichnet, daß** die Kalibrierungseinrichtungen ein Tiefpaßfilter (LPF) aufweisen, das während der Kalibrierungsphase in einer Schleife zur Speichereinrichtung zurück verbunden ist.

10. Anordnung nach Anspruch 9, **dadurch gekennzeichnet, daß** das Tiefpaßfilter mindestens eine Einrichtung zum Verschieben von Bits nach links (DL1,DL2, DL3) aufweist, die zwischen dem Ausgang der Speichereinrichtung (RG) und - über einen Addierer (ADD) - dem Eingang der Speichereinrichtung (RG)) angeordnet ist, sowie eine zusätzliche Einrichtung zum Verschieben von Bits nach links (DLS) aufweist, die zwischen dem zweiten Ausgang (SX2) des Multiplexers (MX1) und dem Addierer (ADD) angeordnet ist.

**Claims**

1. Process for converting an analogue signal into a digital signal with automatic gain control, **characterized in that** the analogue signal (SA) is input to an analogue/digital converter of delta-sigma type (CAN) having an output sampling frequency (Fs) and the automatic gain control (AGC) is performed in the converter, downstream of the delta-sigma modulator (MDU) of the converter, on an intermediate digital signal sampled at an intermediate sampling frequency (8Fs) greater than the output sampling frequency (Fs).

2. Process according to Claim 1, **characterized in that** the automatic gain control is performed on the samples of the intermediate signal which are delivered by a comb decimator filter (CMF) connected to the output of the delta-sigma modulator (MDU).

3. Process according to Claim 1 or 2, **characterized in that** it comprises a phase of prior calibration of the converter, in which a constant analogue calibration signal (SCAL) is input to the converter, and a digital calibration word (RG) is formulated at a calibration location of the converter situated between the modulator and the place where the automatic gain control is performed, on the basis of the digital samples delivered at this calibration location, and **in that**, once this calibration phase has been performed, the digital calibration word is subtracted from each sample delivered to the said calibration location and emanating from the analogue input signal to be converted, in such a way as to form intermediate digital samples on which the automatic gain control is performed.

4. Process according to Claims 2 and 3, **characterized in that** the said calibration location is situated at the output of the comb decimator filter (CMF).

5. Process according to Claim 3 or 4, **characterized in that** during the calibration phase the formulation of the digital calibration word comprises a low-pass filtering (LPF) of the digital samples delivered to the said calibration location.

6. Device for analogue/digital conversion with automatic gain control, **characterized in that** it comprises an analogue/digital converter of the delta-sigma type (CAN) comprising a delta-sigma modulator (MDU) and an output decimator filter (FIR1, FIR2), and means of automatic gain control (AGC) incorporated into the converter (CAN) between the modulator (MDU) and the output decimator filter (FIR1, FIR2).

7. Device according to Claim 6, **characterized in that** the converter (CAN) also comprises a comb decimator filter (CMF) arranged between the modulator (MDU) and the output filter (FIR1), and **in that** the means of automatic gain control (AGC) are arranged between the comb filter (CMF) and the output filter (FIR1).

8. Device according to Claim 7, **characterized in that** it comprises calibration means (MCAL) comprising
   a multiplexer (MX1) possessing an input (EX1) connected to the output of the comb decimator filter (CMF) and a first and a second output (SX1, SX2),
   subtraction means (MST) possessing a first input (ES1) connected to the first output (EX1) of the multiplexer, a second input (ES2) and an output (SS2) which is linked to the input of the automatic gain control means (AGC),
   a memory means (RG) connected between the second output (SX2) of the multiplexer and the second input (ES2) of the subtraction means, and
   drive means (MCD) able to link the input (EX1) of the multiplexer (MX1) to its second output (SX2) during a calibration phase so as to store in the memory means (RG) a digital calibration word in response to a constant analogue calibration signal (SCAL) present at the input of the converter, and to link the input (EX1) of the multiplexer (MX1) to its first output (SX1) in a phase of normal operation of the converter.

9. Device according to Claim 8, **characterized in that** the calibration means comprise a low-pass filter (LPF) looped back to the memory means during the calibration phase.

10. Device according to Claim 9, **characterized in that** the low-pass filter comprises at least one means of shifting bits leftward (DL1, DL2, DL3) connected between the output of the memory means (RG) and the input of the memory means (RG) by way of an adder (ADD), as well as an additional means of leftward shifting of bits (DLS) connected between the second output (SX2) of the multiplexer (MX1) and the adder (ADD).

# FIG.1
## ART ANTERIEUR

SA > ⟩ — ADC — @(Fs) — AGC — @(Fs)

SI

SS

# FIG.2
## ART ANTERIEUR

AGC

@(Fs) > — ⊗ — @(Fs)

CDC ← CMP

+

−TH

10

# FIG.3
## ART ANTERIEUR

# FIG.4

EP 1 077 530 B1

## FIG.5

## FIG.6

# FIG.7

# FIG.8

**FIG.9**

## FIG.10

EP 1 077 530 B1